(19) **Europäisches Patentamt / European Patent Office / Office européen des brevets**

(11) **EP 4 678 396 A1**

(12) **EUROPEAN PATENT APPLICATION**
published in accordance with Art. 153(4) EPC

(43) Date of publication:
**14.01.2026 Bulletin 2026/03**

(21) Application number: **24766942.7**

(22) Date of filing: **27.02.2024**

(51) International Patent Classification (IPC):
**B32B 27/00** (2006.01)    **B32B 27/20** (2006.01)
**B32B 27/30** (2006.01)    **B65D 85/90** (2006.01)

(52) Cooperative Patent Classification (CPC):
**B32B 27/00; B32B 27/20; B32B 27/30; H01L 21/00**

(86) International application number:
**PCT/JP2024/006989**

(87) International publication number:
**WO 2024/185571 (12.09.2024 Gazette 2024/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.03.2023 JP 2023033734**

(71) Applicant: **Denka Company Limited
Chuo-ku
Tokyo 103-8338 (JP)**

(72) Inventors:
• **YANAKA, Ryosuke
Tokyo 103-8338 (JP)**
• **INODA, Ikuka
Tokyo 103-8338 (JP)**
• **SODA, Katsufumi
Tokyo 103-8338 (JP)**

(74) Representative: **Hoffmann Eitle
Patent- und Rechtsanwälte PartmbB
Arabellastraße 30
81925 München (DE)**

(54) **SHEET HAVING BASE MATERIAL LAYER CONTAINING ABS-BASED RESIN**

(57)    Provided is a sheet that has a substrate layer with an ABS-based resin as a main component and that has excellent processability with little occurrence of burrs and fluff.
    Provided is a sheet having a substrate layer comprising an ABS-based resin as a main component and an electrically conductive layer laminated on at least one surface of the substrate layer, wherein the ABS-based resin comprises a grafted rubber having a specific volume particle diameter distribution width and D90.

EP 4 678 396 A1

**Description**

**TECHNICAL FIELD**

The present invention relates to a sheet having a base material layer including an ABS-based resin as the main component. Further, the present invention also relates to a molded article that includes the sheet having a base material layer including an ABS-based resin as the main component.

**BACKGROUND**

Physical and chemical properties are excellent in sheets having a base material (substrate) layer including an ABS-based resin as the main component, so these sheets are used in various applications. In particular, sheets that have an electrically conductive layer that suppresses the occurrence of static electricity in addition to the substrate layer including an ABS-based resin as the main component are often used as sheets for packaging various intermediate or final industrial products that include electronic components.

The abovementioned sheets are typically processed into molded articles and used to package industrial products. Accordingly, there is a need for sheets having good processability. For example, when the molded article is a molded article for packaging a small and precise electronic component such as an embossed carrier tape, there is the possibility that burrs and fluff that arise when the sheet is cut, holes are opened in the sheet, etc. can cause serious faults in the electronic component. Accordingly, there is a particular need for resin sheets with excellent processability in which burrs or fluff do not readily occur.

Many attempts to improve the processability of sheets having a substrate layer with an ABS-based resin as the main component have been reported. For example, Patent Document 1 indicates that the processability of a surface conducting laminated sheet is improved by making an ABS-based resin having a specific composition into a substrate layer.

Patent Document 1: JP 2012-51249 A

**SUMMARY OF INVENTION**

The present invention addresses the problem of providing a sheet that has excellent processability and has a substrate layer that includes an ABS-based resin as the main component.

The present inventors surprisingly found that by using an ABS-based resin including a grafted rubber having a specific volume particle diameter and volume particle diameter distribution width in a sheet having a substrate layer including the ABS-based resin as the main component and an electrically conductive layer laminated on at least one surface of the substrate layer, processability of the sheet is improved, completing the present invention.

That is, the embodiments indicated below are provided according to the present invention.

[1] A sheet having a substrate layer including an ABS-based resin as the main component and an electrically conductive layer laminated on at least one surface of the substrate layer,

wherein the ABS-based resin includes a grafted rubber,

the volume particle diameter distribution width of the grafted rubber is calculated according to formula (1):

$$\text{volume particle diameter distribution width } (D90-D10)/D50 \ldots \text{ formula (1)}$$

wherein D90 is a volume particle diameter ($\mu$m) that 90% of the particles of the grafted rubber are smaller than, D50 is a volume particle diameter ($\mu$m) that 50% of the particles of the grafted rubber are smaller than and the remaining 50% are larger than or equal to, and D10 is a volume particle diameter ($\mu$m) that 10% of the particles of the grafted rubber are smaller than,

and is 2.0 or less, and

the D90 of the grafted rubber is 2.0 to 8.0 $\mu$m.

[2] The sheet described in [1], wherein the electrically conductive layer is the outermost layer.

[3] The sheet described in [1] or [2], wherein the Charpy impact strength of the substrate layer is evaluated with an evaluation method in accordance with JIS-K-7111-1 and is 10 kJ/m$^3$ or greater.

[4] The sheet described in any of [1] to [3], wherein the ABS-based resin includes 20 to 40% by mass of the grafted rubber and 60 to 80% by mass of a copolymer of acrylonitrile and styrene with respect to the total mass of the ABS-based resin, the grafted rubber includes 5 to 15% by mass of acrylonitrile, 40 to 60% by mass of butadiene, and 25 to 55% by mass of styrene with respect to the total mass of the grafted rubber, and the graft rate of the grafted rubber is 100 to 140%.

[5] The resin sheet described in [4], wherein the copolymer of acrylonitrile and styrene includes 20 to 40% by mass of acrylonitrile and 60 to 80% by mass of styrene with respect to the total mass of the copolymer of acrylonitrile and has a weight-average molecular weight of 80,000 to 200,000.

[6] The resin sheet described in any of [1] to [5] wherein the sheet is a sheet for electronic component packaging.

[7] A molded article including the sheet described in any of [1] to [6].

[8] The molded article described in [6] wherein the molded article is for packaging an electronic component.

[9] The molded article described in [7] or [8] wherein the molded article is a container.

[10] The molded article described in [7] or [8] wherein the molded article is a carrier tape.

The present invention can provide a sheet that has excellent processability and has a substrate layer including an ABS-based resin as the main component.

## BRIEF DESCRIPTION OF DRAWINGS

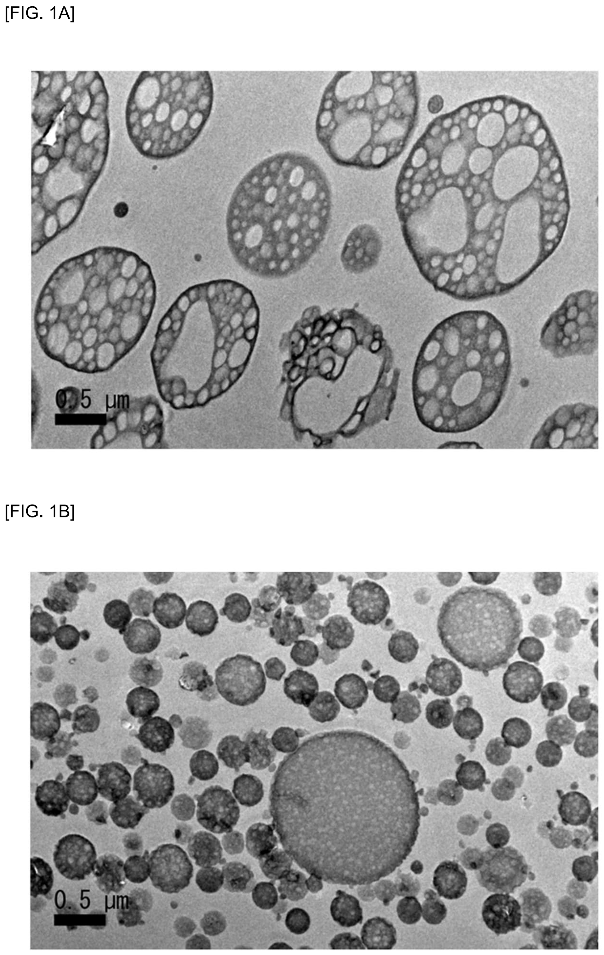

Fig. 1A is a transmission electron microscope (TEM) photograph of the ABS-based resin raw material of Example 3. The photograph was taken of an ultrathin ABS resin strip that was stained with osmium tetraoxide (OsO$_4$).
Fig. 1B is a transmission electron microscope (TEM) photograph of the ABS-based resin raw material of Comparative Example 4. The photograph was taken of an ultrathin ABS resin strip that was stained with osmium tetraoxide (OsO$_4$).

## DESCRIPTION OF EMBODIMENTS

[Explanation of terms]

"Main component" in the present disclosure means a component where the proportion of the component is 50% by mass or greater, preferably 70% by mass or greater, and more preferably 90% by mass or greater with respect to the total mass of the composition or the like including the component. For example, the expression "substrate layer including an ABS-based resin as the main component" means a substrate layer that includes 50% by mass or greater, preferably 70% by mass or greater, and more preferably 90% by mass or greater of the ABS-based resin.
In the present disclosure, numerical ranges written using the expression "to" or "-" mean that both the upper limit and the lower limit are included. For example, the description "A to B" or "A-B" using the numerical values A and B means that the value is A or greater and B or less. Further, the descriptions "A to B", "A-B", or "A or greater and B or less" independently include both "A or greater is preferable" and "B or less is preferable".
When multiple numerical ranges are described for specific parameters in the present disclosure, a suitable numerical range can be set by combining any upper limit and lower limit among the upper limits and lower limits in the numerical ranges. Further, the lower limits or upper limits of numerical ranges described in the present disclosure may be substituted with values within these numerical ranges that are indicated in examples.
In the present disclosure, "and/or" includes both the relationship represented by "and" and the relationship represented by "or". "And" is also represented by "and" or "and". "Or" is also expressed as "or".
"Include" in the present disclosure includes "is formed mainly from", "is essentially formed from", and "comprises". "Is essentially formed from" and "comprises" are included in "is formed mainly from" and "comprises" is included in "is essentially formed from".
In the present disclosure, subjects expressed in the singular with "a", "an", "the", etc. encompass singular and plural subjects unless specially and clearly indicated.

Hereafter, embodiments of the present invention shall be explained in detail, but the present invention is not limited to these embodiments and can be implemented by adding appropriate modifications as long as the effects of the present invention are not impaired. These embodiments may be used alone or multiple embodiments may be combined. When a specific explanation written for a given embodiment also applies to another embodiment, there are cases in which that explanation is omitted for the other embodiment. The publicly known features and procedures described in the present description are sufficiently understood by those skilled in the art and can be performed in accordance with the usual methods.

The present disclosure relates to a sheet having a substrate layer including an ABS-based resin as the main component (hereafter also simply written as "sheet"). Further, the present invention also relates to a molded article that includes the sheet having a substrate layer that includes an ABS-based resin as the main component.

[Sheet]

The "sheet" according to the present embodiment is characterized by having a substrate layer including an ABS-based resin as the main component and an electrically conductive layer laminated on at least one surface of the substrate layer, the ABS-based resin including a grafted rubber, the volume particle diameter distribution width of the grafted rubber calculated according to formula (1):

$$\text{volume particle diameter distribution width } (D90-D10)/D50 \ldots \text{ formula (1)}$$

wherein D90 is a volume particle diameter ($\mu$m) that 90% of the particles of the grafted rubber are smaller than, D50 is a volume particle diameter ($\mu$m) that 50% of the particles of the grafted rubber are smaller than and the remaining 50% are larger than or equal to, and D10 is a volume particle diameter ($\mu$m) that 10% of the particles of the grafted rubber are smaller than, being 2.0 or less, and the grafted rubber having a D90 within the range of 2.0 to 8.0 $\mu$m. The sheet according to the present embodiment has excellent processability and the occurrence of burrs and fluff is effectively suppressed therein.

<Base material layer>

The sheet according to the present embodiment is provided with a substrate layer including an ABS-based resin as the main component. Further, the ABS-based resin includes a grafted rubber with a volume particle size distribution width of 2.0 or less as calculated according to abovementioned formula (1) and a D90 in the range of 2.0 to 8.0 $\mu$m.

(ABS-based resin)

The "ABS-based resin" according to the present embodiment is a resin or resin composition including a grafted rubber and preferably is a resin or resin composition including a grafted rubber and a copolymer of acrylonitrile- and styrene-based monomers (AS copolymer). The ABS-based resin may be used alone or two or more may be used in combination.

In one embodiment, the content ratios of the grafted rubber and the AS copolymer are preferably in the ranges of 20 to 40% by mass of the grafted rubber and 60 to 80% by mass of the AS copolymer, and more preferably in the ranges of 20 to 30% by mass of the grafted rubber and 70 to 80% by mass of the AS copolymer.

(Grafted rubber)

The "grafted rubber" according to the present embodiment is preferably a rubber component obtained by graft copolymerizing a vinyl cyanide monomer, a diene-based monomer, and an aromatic vinyl monomer. The vinyl cyanide monomer is preferably acrylonitrile, methacrylonitrile, or ethacrylonitrile and especially preferably acrylonitrile. Further, the diene-based monomer is preferably 1,3-butadiene (hereafter simply described as "butadiene"), 1,3-pentadiene, or 2-methyl-1,3-butadiene (isoprene) and is especially preferably butadiene. Further, the aromatic vinyl monomer is preferably styrene, $\alpha$-methylstyrene, p-methylstyrene, or o-methylstyrene and is especially preferably styrene. The aromatic vinyl monomer may be used alone or two or more may be used in combination. The grafted rubber is especially preferably a rubber component obtained by graft copolymerizing acrylonitrile, butadiene, and styrene.

The weight-average molecular weight (Mw) of the graft chains in the grafted rubber is not particularly limited so long as the effects of the present invention are not impaired, but is typically 18,000 to 56,000. The weight-average molecular weight (Mw) of the graft chains in the grafted rubber can be evaluated with a publicly known method as described in, for example, JP 2012-51249 A.

In one embodiment, the volume particle size distribution width of grafted rubber having the volume particle size distribution width represented by formula (1) above is 2.0 or less, preferably 1.5 or less, and more preferably 1.0 or less from the perspective of punching burr characteristics. In one embodiment, the volume particle size distribution width of the grafted rubber represented by formula (1) may be 0.5 to 2.0 or may be 0.5 to 1.5.

D90 of the grafted rubber is 2.0 to 8.0 $\mu$m, as discussed above. By including a grafted rubber with a D90 of 2.0 to 8.0 $\mu$m and a volume particle size distribution width of 2.0 or less as represented by Formula (1), a substrate layer in which burring during punching can be suppressed and which has sufficient strength can be configured. By providing such a substrate layer, the sheet according to the present embodiment becomes that with excellent processability.

In one embodiment, D90 of the grafted rubber may be 2.0 to 6.0 $\mu$m, may be 4.0 to 6.0 $\mu$m, may be 2.0 to 4.0 $\mu$m, or may be 2.0 to 3.0 $\mu$m. Further, D50 of the grafted rubber is preferably 0.9 to 3.8 $\mu$m and more preferably 1.5 to 3.0 $\mu$m. D10 of the grafted rubber is preferably 0.3 to 2.8 $\mu$m and more preferably 1.0 to 2.0 $\mu$m. D90, D50, and D10 of the grafted rubber are in the relationship D90 > D50 > D10 in light of the measurement principles.

D90, D50, and D10 of the grafted rubber can be determined with publicly known methods. Typically, D90, D50, and D10 are measured using a commercially available laser diffraction/scattering-type particle distribution measuring instrument (for example, laser micron sizer LMS-2000e manufactured by SEISHIN ENTERPRISE Co., Ltd.) with an ABS resin sample in accordance with the instruction manual for the measuring instrument, using dimethylformamide as a dispersion medium.

In one embodiment, grafted rubber including 5 to 15% by mass of acrylonitrile (An), 40 to 60% by mass of butadiene (Bd), and 25 to 55% by mass of styrene (St) with respect to the total mass of the grafted rubber can be used as the grafted rubber.

If the compositions of An, Bd, and St in the grafted rubber are within the abovementioned ranges, an ABS-based resin with a good balance of various mechanical properties is readily obtained.

Moreover, if the content rate of Bd is the lower limit discussed above or greater, mechanical properties of the ABS-based resin in terms of impact strength, anti-folding strength, breaking elongation, etc. tend to readily improve. Further, if the content rate of Bd is the upper limit discussed above or less, strength properties of the ABS-based resin such as yield strength tend to readily improve. By setting the Bd content within the abovementioned range, sheets with good processability are readily obtained.

In one embodiment, it is preferred that the graft rate of the grafted rubber is typically 100 to 140%. The graft rate may be 100 to 120% or may be 120 to 140%.

Typically, the graft rate can be measured with the following method.

About 20 g of the resin composition is dispersed in 100 ml of methanol and the solid components are filtered by suction filtration using a filter paper. The filtered solid components are dried for 24 hours at room temperature and then for about 4 hours with a vacuum drier. About 1.2 g of the dried solid components are placed in a 100 ml triangular flask and 30 g of methyl ethyl ketone (MEK) is added thereto. This is separated into a supernatant liquid and a sediment by stirring for 24 hours at 23° C, subjecting the solution to a centrifuge (for example, CR26H manufactured by Hitachi, Ltd., set to temperature: -9° C, rotation speed: 23,000 rpm, and time: 50 minutes) and letting the solution stand for a further 30 minutes. The supernatant liquid is poured into a 300 ml beaker containing 150 ml of methanol and the precipitate is filtered by suction filtration using a filter paper. The filtered precipitate is dried for 24 hours at room temperature and then for about 4 hours with a vacuum drier. The grafted rubber is isolated from the resin composition by performing the abovementioned steps of adding MEK, stirring, centrifugal separation, letting stand, precipitation, suction filtration, and drying once more on the obtained dry matter. The mass of the An monomer (y) included in the isolated grafted rubber is quantified with the Kjeldahl nitrogen method and the mass (z) of the St monomer is quantified by pyrolysis gas chromatography. The graft rate is calculated from the quantity values according to the formula: graft rate (%) = $100\times(y+z)/\{x-(y+z)\}$. Here, (x) is the mass of the grafted rubber used in the quantification.

The occurrence of burrs and fluff during processing readily decreases in a sheet having a substrate layer that includes an ABS-based resin in which the graft rate is the abovementioned lower limit or greater as the main component. Further, synthesis is easier with an ABS-based resin in which the graft rate is the abovementioned upper limit or less, and sufficient strength is readily obtained using a sheet having a substrate layer that includes such an ABS-based resin as the main component as, for example, a sheet for electronic component packaging.

The graft rate of the grafted rubber varies strictly according to the manufacturing methods of the ABS-based resins, but can be set by adjusting general polymerization conditions such as the amount of polymerization initiator to be added, the amount of chain transfer agent to be added and the time at which it is added, and the temperature control during polymerization. Further, an ABS-based resin containing a grafted rubber having a graft rate in this range can be obtained commercially.

(AS copolymer)

The ABS resin in the present embodiment can include an AS copolymer. An AS copolymer is a copolymer obtained by copolymerizing acrylonitrile- and styrene-based monomers. The same styrene-based monomers used to obtain the grafted rubber discussed above can be used as the styrene-based monomer and the preferred examples are also the same. The AS copolymer is especially preferably a copolymer of acrylonitrile and styrene.

In one embodiment, an AS copolymer including 20 to 40% by mass of acrylonitrile (An) and 60 to 80% by mass of styrene (St) with respect to the total mass of the AS copolymer is preferably used as the AS copolymer. The AS copolymer more preferably may include 20 to 30% by mass of An and 70 to 80% by mass of St with respect to the total mass of the AS copolymer.

If the compositions of An and St in the AS copolymer are within these ranges, extrusion moldability of the sheet readily becomes favorable.

In one embodiment, the weight-average molecular weight of the AS copolymer is preferably 80,000 to 200,000 and more preferably 100,000 to 150,000. If the weight-average molecular weight of the AS copolymer is 80,000 or greater, the DuPont impact strength and anti-folding strength do not readily decrease, and if the weight-average molecular weight is 200,000 or less, the occurrence of burrs is readily suppressed. The weight-average molecular weight of the AS copolymer can be determined according to, for example, a molecular weight distribution curve using GPC (gel permeation chromatography).

(Other components)

In one embodiment, the substrate layer may include resin components other than the ABS-based resin (other resins) or various additives in a range not exceeding 50% by mass. Examples of other resins include polycarbonate (PC) resins, polybutylene terephthalate (PBT) resins, etc., but the other resins are not limited thereto. Examples of additives include modifiers, lubricants, plasticizers, and processing aids, but the additives are not limited thereto.

Further, the substrate layer may include recycled materials. Recycled materials are generally materials where portions at both ends (generally called "edges") of sheets generated when extruding a resin sheet in manufacturing processes for resin sheets or trimmed portions that cannot be made into products such as the initial end portion when winding a sheet are crushed, re-pelletized, and reused. When the substrate layer includes a recycled material, the content of components that the substrate layer includes can also be adjusted according to the content of the components that the recycled material includes. In one embodiment, the substrate layer includes 2 to 30% by mass, preferably 2 to 30% by mass, and more preferably 2 to 20% by mass of recycled material with respect to the total mass of the substrate layer.

In one embodiment, the substrate layer may include trace components derived from raw materials or other trace components so long as the effects of the present invention are not impaired. Examples of such trace components include $\alpha$-methylstyrene, vinyltoluene, dimethylstyrene, chlorostyrene, vinylnaphthalene, methacrylonitrile, ethacrylonitrile, fumaronitrile, etc., but the trace components are not limited thereto. Although descriptions of trace components are omitted below, the electrically conductive layer, resin, polymer, composition, resin composition, etc. in the present embodiment all include those which contain such trace components in a range that does not impair the effects of the present invention.

(Charpy impact strength)

In one embodiment, the Charpy impact strength of the substrate layer is preferably 10 kJ/m$^3$ or greater and more preferably 10 kJ/m$^3$ to 20 kJ/m$^3$. In general, if the Charpy impact strength of the substrate layer is 10 kJ/m$^3$ or greater, the strength (especially toughness) of the substrate layer readily becomes favorable, and a sheet having such a substrate layer can be suitably used as, for example, a sheet for electronic component packaging.

The Charpy impact strength of the substrate layer is typically evaluated with an evaluation method according to JIS-K-7111-1, employing edgewise as the striking direction for notched test pieces made using the resin composition for the substrate layer. Note that commercially available impact testing equipment (for example, a digital impact tester manufactured by Toyo Seiki Seisaku-sho, Ltd.) can be used as the measurement device. In the resin composition according to the present embodiment, notched test pieces can be made using a resin composition including the abovementioned ABS-based resin and measured with the abovementioned method.

<Electrically conductive layer>

The sheet according to the present embodiment is provided with an electrically conductive layer laminated on at least one surface of the abovementioned substrate layer. The electrically conductive layer may be laminated on one surface of the substrate layer or may be laminated on both surfaces of the substrate layer. In one embodiment, the electrically conductive layer is preferably the outermost layer of the sheet. When the electrically conductive layer is on the outermost layer of the sheet, for example, burrs and fluff tend to less readily occur during sheet punching and the processability of the sheet tends to improve.

The electrically conductive layer is not particularly limited so long as it is a layer including an electrically conductive component. Carbon black is suitably used as the electrically conductive component. Examples of carbon black include furnace black, channel black, acetylene black, etc., but the carbon black is not limited thereto. Carbon black having a volume particle diameter with a large specific surface area such that a high electrical conductivity is obtained with a small amount added is preferred. Specifically, the average primary volume particle diameter of the carbon black is preferably 10 to 100 nm and more preferably 20 to 60 nm. The average primary volume particle diameter can be measured using, for example, a transmission electron microscope.

The electrically conductive layer preferably includes 5 to 40% by mass and more preferably 10 to 30% by mass of the electrically conductive component. Further, the electrically conductive layer may include one or more resins among polystyrene-based resins, ABS-based resins, polyvinyl chloride-based resins, polypropylene-based resins, polyester-based resins, polyphenylene ether-based resins, polybutylene terephthalate-based resins, and polycarbonate-based resins and in this case, the electrically conductive layer preferably includes 60 to 95% by mass and more preferably 70 to 90% by mass thereof.

The electrically conductive layer may include various additives. Examples of additives include modifiers, lubricants, plasticizers, and processing aids, but the additives are not limited thereto.

Further, the electrically conductive layer may include the abovementioned recycled materials so long as the effects of the present invention are not impaired. In this case, the content of components that the electrically conductive layer includes can also be adjusted according to the content of the components that the recycled material includes. In one embodiment, the substrate layer includes 2 to 30% by mass, preferably 2 to 30% by mass, and more preferably 2 to 20% by mass of recycled material with respect to the total mass of the components constituting the electrically conductive layer.

<Thicknesses of the substrate layer and electrically conductive layer, total thickness of the sheet, etc.>

The thicknesses of the substrate layer and electrically conductive layer and the total thickness of the sheet can be set to any thickness as long as the effects of the present invention are not impaired. For example, the thickness of the substrate layer may preferably be 50 to 700 $\mu$m, more preferably 75 to 500 $\mu$m, and still more preferably 100 to 300 $\mu$m. The thickness of the electrically conductive layer may preferably be 1 to 100 $\mu$m, more preferably 5 to 75 $\mu$m, and still more preferably 10 to 50 $\mu$m. The total thickness of the sheet may preferably be 51 to 800 $\mu$m, more preferably 80 to 150 $\mu$m, and still more preferably 110 to 350 $\mu$m.

In one embodiment, the ratio of the thickness of the substrate layer and the thickness of the electrically conductive layer (substrate layer thickness/electrically conductive layer thickness) may be in the range from 90/10 to 60/40.

These thicknesses can be evaluated with publicly known methods. For example, these thicknesses may be evaluated using a microscope or the like. Specifically, these thicknesses may be evaluated by using a shape-analyzing laser microscope (for example, shape measurement laser microscope VK-X100 manufactured by Keyence Corporation) to measure the thicknesses of the layers in a cross section of a sample that was cut out with a single-edged knife. When the sheet is extruded with an extruder, these thicknesses are typically evaluated from average values of the measurements at the center and at both ends of the cross section in a direction perpendicular to the direction of flow of the sheet.

The sheet according to the present embodiment may also have optional layers beyond the substrate layer and the electrically conductive layer. Further, the substrate layer and the electrically conductive layer each may be a single-layer structure or may be a multilayer structure. When including an optional layer, providing the optional layer such that the electrically conductive layer is the outermost layer is preferred from the viewpoint of readily suppressing burrs and fluff during sheet punching.

[Use]

The sheet according to the present embodiment is typically a sheet that can be used as a material of a molded body for packaging an intermediate or final industrial product. The industrial product is typically an electronic component or a product that includes electronic components. That is, in the present embodiment, the sheet may be used as a sheet for electronic component packaging. Examples of electronic components or products including electronic components include semiconductors, integrated circuits (ICs), light-emitting diodes (LEDs), diodes, resistors, capacitors, transistors, piezoelectric element registers, filters, crystal oscillators, crystal resonators, connectors, switches, volumes, relays, inductors, and combinations thereof, but the electronic components or products including the same are not limited thereto. There are also use of the abovementioned sheet as a sheet for electronic component packaging and methods of use thereof as other embodiments of the abovementioned sheet.

The sheet according to the present embodiment has good processability. For example, the sheet according to the present embodiment has the property of burrs and fluff not readily occurring when the sheet is cut, a hole is opened in the resin, etc. Therefore, for example, there is little possibility of a fault occurring in an electronic component due to burrs or fluff when the electronic component is packaged by a molded article that includes the sheet according to the present embodiment. Note that sheets in which burrs and fluff do not readily occur generally tend to have low strength, which tends to make such inappropriate for use as sheets for electronic component packaging, for example. However, the sheet according to the present embodiment retains suitable strength and can be used appropriately as, for example, a sheet for electronic component packaging.

[Method of manufacturing the sheet]

In these embodiments the method of manufacturing the sheet is not particularly limited and the sheet can be manufactured with general methods. For example, the sheet is suitably manufactured by respectively providing the raw materials constituting the substrate layer and the electrically conductive layer to separate extruders and extrusion-molding using a multilayer T-die having a multi-manifold or a T-die extrusion-molding method using a feed block.
Note that in these manufacturing methods, portions at both ends (generally called "edges") of sheets generated in sheet extrusion processes or trimmed portions that cannot be made into products such as the initial end portion when winding a sheet can generally be as recycled materials by crushing and re-pelletizing. In the abovementioned embodiments, such recycled materials can be included in the substrate layer, electrically conductive layer, etc. as long as the effects of the present invention are not lost.

[Molded article and manufacturing method therefor]

In these embodiments, the molded article can be obtained by processing a sheet according to these embodiments. Processing the sheet can be carried out with publicly known methods including vacuum molding, pressure molding, press molding, etc. Further, processing the sheet may include a step of cutting the sheet into a desired shape or a step of punching sprocket holes into the sheet.
The molded article according to the present embodiment is typically a molded article for packaging an electronic component. In one embodiment, the molded article may be a container and in particular may be a container having a storage part for storing an electronic component. Further, in one embodiment, the molded article may be a carrier tape and in particular may be a carrier tape on which an embossing process has been performed.

EXAMPLES

The present invention will be explained in detail by indicating examples below, but the present invention is not limited by the descriptions below.

[Fabrication of the sheet]

ABS-based resin raw materials in which grafted rubbers 1 to 7 shown in Table 1 and the AS copolymer shown in Table 2 were blended at the compositions shown in Table 3 were prepared by publicly known methods. The compositions used for substrate layers were made by respectively weighing 10 parts by mass of recycled material with respect to 100 parts by mass of ABS-based resin raw material and mixing them uniformly in a high-speed mixer. Note that the recycled materials that were used are recycled materials where the abovementioned portions at both ends (edges) of sheets extruded from a T-die or trimmed portions that cannot be made into products such as the initial end portion when winding a sheet were crushed and re-pelletized. Further, the recycled materials used in Examples 1 to 3 and Comparative Examples 1 to 4 are recycled materials obtained from the manufacturing processes of Examples 1 to 3 and Comparative Examples 1 to 4, respectively.
D90, D50, and D10 of the grafted rubbers were measured using a laser micron sizer LMS-2000e manufactured by SEISHIN ENTERPRISE Co., Ltd. with an ABS resin sample in accordance with the descriptions in the instruction manual for the measuring instrument, using dimethylformamide as a dispersion medium.
Note that in the following tables, An means acrylonitrile, St means styrene, Bd means butadiene, PC means polycarbonate, PBT means polybutylene terephthalate, CB means carbon black, and Mw means weight-average molecular weight.

Table 1

| | | D90 (μm) | D50 (μm) | D10 (μm) | VOLUME PARTICLE DIAMETER WIDTH (μm) | An PROPORTION (%) | St PROPORTION (%) | Bd PROPORTION (%) | GRAFT RATE (%) |
|---|---|---|---|---|---|---|---|---|---|
| GRAFTED RUBBER | 1 | 6.0 | 3.0 | 1.4 | 1.5 | 45 | 45 | 10 | 120 |
| | 2 | 2.0 | 1.0 | 1.0 | 1.0 | | | | |
| | 3 | 3.0 | 2.3 | 1.8 | 0.5 | | | | |
| | 4 | 1.0 | 0.8 | 0.6 | 0.5 | | | | |
| | 5 | 10.0 | 6.0 | 4.0 | 1.0 | | | | |
| | 6 | 10.0 | 3.0 | 1.0 | 3.0 | | | | |
| | 7 | 5.0 | 1.5 | 0.5 | 3.0 | | | | |

Table 2

| | An | St | Mw× 10,000 |
|---|---|---|---|
| AS COPOLYMER | 25 | 75 | 13.5 |

Table 3

| | | EXAMPLES | | | COMPARATIVE EXAMPLES | | | |
|---|---|---|---|---|---|---|---|---|
| | | 1 | 2 | 3 | 1 | 2 | 3 | 4 |
| GRAFTED RUBBER | 1 | 25 | | | | | | |
| | 2 | | 25 | | | | | |
| | 3 | | | 25 | | | | |
| | 4 | | | | 25 | | | |
| | 5 | | | | | 25 | | |
| | 6 | | | | | | 25 | |
| | 7 | | | | | | | 25 |
| AS COPOLYMER | | 75 | 75 | 75 | 75 | 75 | 75 | 75 |

Fig. 1A and Fig. 1B show transmission electron microscope (TEM) photographs of the ABS-based resin raw materials of Example 3 and Comparative Example 4, respectively. A relatively large spherical grafted rubber of uniform size is observed in the ABS-based resin raw material of Example 3, which has a narrow volume particle size distribution width. Meanwhile, in the ABS-based resin raw material of Comparative Example 4, which has a wide volume particle size distribution width, a relatively small non-uniform spherical grafted rubber of various sizes is observed.
The ABS-based resin raw material in Example 3 has a more uniform grafted rubber size as compared with the ABS-based resin raw material in Comparative Example 4 and this is thought to tend to cause uniform breakage and therefore to improve punching burr characteristics. Further, the ABS-based resin raw material in Example 3 is thought to tend to have an elevated Charpy impact strength in comparison with the ABS-based resin raw material with a grafted rubber of smaller size due to the large size of the grafted rubber.

A composition was prepared by using a φ 30 mm vented twin-screw extruder to knead 80% by mass of a polycarbonate-based resin (manufactured by Teijin Ltd., product name "Panlite® L-1225L") and 20% by mass of acetylene black (manufactured by Denka Company Limited, product name: "DENKA BLACK® Granular", average primary volume particle diameter: 35 nm) as the electrically conductive material and pelletizing with a strand cutting method as the composition used in the electrically conductive layer.

Note that the average primary volume particle diameter of acetylene black in the electrically conductive layer is determined by the following method.
First, a dispersion sample was prepared by using an ultrasonic disperser to disperse acetylene black in chloroform for 10 minutes under conditions of 150 kHz and 0.4 kW. This dispersion sample was fixed by being sprinkled on a carbon-reinforced support film, and this was then captured with a transmission electron microscope (JEM-2100, manufactured by JEOL Ltd). 1,000 or more particle diameters (maximum diameter for shapes other than a sphere) of an inorganic filler were measured randomly using an Endter device from an image magnified to 50,000 to 200,000×, and the average value thereof was used as the average primary particle diameter.

Sheets having the electrically conductive layer on both surfaces of the substrate layer were obtained by processing the compositions used in the substrate layer and the composition used in the electrically conductive layer with a feed block method using a φ 65 mm extruder (L/D = 28), a φ 50 mm extruder (L/D = 28), a φ 40 mm extruder (L/D = 26), and a T-die with a width of 500 mm. The thickness of the electrically conductive layer, the thickness of the substrate layer, and the total thickness of the sheet in the obtained sheets were as shown as shown in Table 4. Note that these thicknesses are the average of the thicknesses at both ends and at the center of cross sections in the direction perpendicular to the sheet flow direction, as measured with a laser microscope for shape analysis (VK-X100 laser microscope for shape measurement, manufactured by Keyence Corporation) on pieces of sheets cut out with a single-edged knife.

Table 4

| | | | | | EXAMPLE 1 | | EXAMPLE 2 | | EXAMPLE 3 | | COMPARATIVE EXAMPLE 1 | | COMPARATIVE EXAMPLE 2 | | COMPARATIVE **EXAMPLE 3** | | COMPARATIVE EXAMPLE 4 | |
|---|---|---|---|---|---|---|---|---|---|---|---|---|---|---|---|---|---|---|
| SUBSTRATE LAYER | COMPOSITION | GRAFTED RUBBER | D90 | (μm) | 8 | | 2 | | 1 | | 1 | | 10 | | 5 | | 5 | |
| | | | VOLUME PARTICLE DIAMETER WIDTH | (μm) | 1.5 | | 1 | | 0.5 | | 0.5 | | 1 | | 3 | | 3 | |
| | | | An | MASS% | 10 | 25 | 10 | 25 | 10 | 25 | 10 | 25 | 10 | 25 | 45 | 25 | 10 | 25 |
| | | | St | | 45 | | 45 | | 45 | | 45 | | 45 | | 45 | | 45 | |
| | | | Bd | | 45 | | 45 | | 45 | | 45 | | 45 | | 10 | | 45 | |
| | | | GRAFT **RATE** | % | 120 | | 120 | | 120 | | 120 | | 120 | | 120 | | 120 | |
| | | AS COPOLYMER | An | MASS% | 25 | 75 | 25 | 75 | 25 | 75 | 25 | 75 | 25 | 75 | 25 | 75 | 25 | 75 |
| | | | St | | 75 | | 75 | | 75 | | 75 | | 75 | | 75 | | 75 | |
| | | | Mw×10,000 | - | 13.5 | | 13.5 | | 13.5 | | 13.5 | | 13.5 | | 13.5 | | 13.5 | |
| | RECYCLED MATERIAL (PARTS BY MASS) | | | | 10 | | 10 | | 10 | | 10 | | 10 | | 10 | | 10 | |
| | SUBSTRATE LAYER THICKNESS | | | (μm) | 172 | | 172 | | 172 | | 172 | | 172 | | 172 | | 172 | |
| ELECTRICALLY CONDUCTIVE LAYER | COMPOSITION | PC | | | 65 | | 65 | | 65 | | 65 | | 65 | | 65 | | 65 | |
| | | PBT | | | 20 | | 20 | | 20 | | 20 | | 20 | | 20 | | 20 | |
| | | CB | | | 15 | | 15 | | 15 | | 15 | | 15 | | 15 | | 15 | |
| | ELECTRICALLY CONDUCTIVE LAYER THICKNESS | | | (μm) | 28 | | 28 | | 28 | | 28 | | 28 | | 28 | | 28 | |
| | TOTAL SHEET THICKNESS | | | (μm) | 200 | | 200 | | 200 | | 200 | | 200 | | 200 | | 200 | |
| EVALUATION | PUNCH BURR PROPERTIES | | | | GOOD | | EXCELLENT | | EXCELLENT | | EXCELLENT | | FAIL | | FAIL | | FAIL | |
| | (NUMBER OF BURRS) | | | | 9 | | 2 | | 2 | | 2 | | 12 | | 15 | | 11 | |
| | SUBSTRATE COMPOSITION CHARPY IMPACT STRENGTH (kJ/m3) | | | | 16 | | 10 | | 14 | | 8 | | 22 | | 25 | | 28 | |

[Sheet evaluation] The sheets of Examples 1 to 3 and Comparative Examples 1 to 4 were cut in the extrusion direction of the sheets to fabricate sheet samples which were left for 24 hours in an atmosphere with a temperature of 23° C and a relative humidity of 50%. The punch burr properties and Charpy impact strength were then evaluated under the following conditions.

(Punch burr properties)

Punching and burrs and fluff in punch holes in sheet samples that were slitted to a width of 8 mm were evaluated using a vacuum rotary molder (product name: "CT 8/24" manufactured by Mühlbauer GmbH & Co. KG) in at atmosphere with a temperature of 23° C and a relative humidity of 50%. Note that punching was performed at a speed of 240 m/h using a punching apparatus provided with a column-type punching pin with a sprocket hole pin tip diameter of 1.5 mm and a die hole with a diameter of 1.58 mm.
The punch holes formed in the sheet described above were captured, in an illumination environment with an incident light of 0%, transmission of 40%, and a ring of 0%, using a measuring microscope (product name "MF-A1720H (image unit 6D)", manufactured by Mitutoyo Corporation). Holes with a diameter of 1.5 mm were observed at ten locations and the number of burrs and fluffs with a length of 0.15 mm or more was counted. Further, evaluations were made in accordance with the following determination criteria, with good or higher being deemed to be a pass (occurrence of burrs and fluffs is inhibited).

<Determination criteria>

   Excellent: Number of burrs, fluffs was less than six

   Good: Number of burrs, fluffs was six or greater and less than ten

   Fail: Number of burrs, fluffs was ten or greater

(Charpy impact strength)

The Charpy impact strength was measured with an evaluation method according to JIS-K-7111-1, using notched test pieces made using the resin compositions for the substrate layer and employing edgewise as the striking direction. Note that a digital impact tester manufactured by Toyo Seiki Seisaku-sho, Ltd. was used as the measurement device. Note that sheets using a substrate layer in which the Charpy impact strength is low generally tend to have less burrs and fluff. However, a sheet using a substrate layer in which the Charpy impact strength is too low is not suitable for use as a sheet for electronic component packaging because strength sufficient for the molding process of the sheet for electronic component packaging is not readily obtained.
As shown in Table 4, the punch burr properties in the compositions of Examples 1 to 3 in which the volume particle diameter distribution width of the grafted rubber particles is 2 or less and D90 of the grafted rubber particles is 2.0 $\mu$m to 8.0 $\mu$m were determined to be excellent or good. Further, these compositions had Charpy impact strengths of 10 kJ/m$^3$ or greater.
Meanwhile, the Charpy impact strength in the composition of Comparative Example 1 in which D90 of the grafted rubber particles is less than 2.0 $\mu$m was lower as compared with the compositions of Examples 1 to 3. Further, the punch burr properties were determined to be failures in the composition of Comparative Example 2 in which D90 of the grafted rubber particles is higher than 8.0 $\mu$m, the composition of Comparative Example 3 in which the volume particle diameter distribution width of the grafted rubber particles is wider than 2 and D90 of the grafted rubber particles is higher than 8.0 $\mu$m, and the compositions of Comparative Example 3 and Comparative Example 4 in which the volume particle diameter distribution width of the grafted rubber particles is wider than 2.
These results indicate that the sheet of the present invention has good processability and in particular can suppress the occurrence of burrs and fluff during sheet punching. That is, the sheet of the present invention is useful for, for example, the application of packaging electronic components, and is capable of effectively suppressing the possibility that faults will occur in electronic components due to burrs or fluff.
Note that the disclosed details of the patents, patent applications, and publications cited in the present disclosure are invoked in their entirety by reference in the present disclosure.

**INDUSTRIAL APPLICABILITY**

The sheet of the present application, which has a substrate layer including an ABS-based resin as the main component, has good processability and therefore can suitably be used as a packaging sheet for industrial products (for example, electronic components including semiconductors, integrated circuits (ICs), light-emitting diodes (LEDs), diodes, resistors, capacitors, transistors, piezoelectric element registers, filters, crystal oscillators, crystal resonators, connectors, switches, volumes, relays, inductors, combinations thereof, etc.). Accordingly, the present invention has industrial applicability.

**Claims**

1. A sheet having a substrate layer comprising an ABS-based resin as a main component and an electrically conductive layer laminated on at least one surface of the substrate layer,

   wherein the ABS-based resin comprises a grafted rubber,
   the volume particle diameter distribution width of the grafted rubber is calculated according to formula (1):

$$\text{volume particle diameter distribution width (D90−D10)/D50 … formula (1)}$$

   wherein D90 is a volume particle diameter ($\mu$m) that 90% of the particles of the grafted rubber are smaller than, D50 is a volume particle diameter ($\mu$m) that 50% of the particles of the grafted rubber are smaller than and the remaining 50% are larger than or equal to, and D10 is a volume particle diameter ($\mu$m) that 10% of the particles of the grafted rubber are smaller than,
   and is 2.0 or less, and
   the D90 of the grafted rubber is 2.0 to 8.0 $\mu$m.

2. The sheet according to claim 1, wherein the electrically conductive layer is an outermost layer.

3. The sheet according to claim 1, wherein the Charpy impact strength of the substrate layer is evaluated with an evaluation method in accordance with JIS-K-7111-1 and is 10 kJ/m$^3$ or greater.

4. The sheet according to claim 1, wherein the ABS-based resin comprises 20 to 40% by mass of the grafted rubber and 60 to 80% by mass of a copolymer of acrylonitrile and styrene with respect to the total mass of the ABS-based resin, the grafted rubber comprises 5 to 15% by mass of acrylonitrile, 40 to 60% by mass of butadiene, and 25 to 55% by mass of styrene with respect to the total mass of the grafted rubber, and the graft rate of the grafted rubber is 100 to 140%.

5. The sheet according to claim 4, wherein the copolymer of acrylonitrile and styrene comprises 20 to 40% by mass of acrylonitrile and 60 to 80% by mass of styrene with respect to the total mass of the copolymer of acrylonitrile and styrene and has a weight-average molecular weight of 80,000 to 200,000.

6. The sheet according to claim 1, wherein the sheet is a sheet for electronic component packaging.

7. A molded article comprising the sheet according to any of claims 1 to 6.

8. The molded article according to claim 7, wherein the molded article is for packaging an electronic component.

9. The molded article according to claim 7, wherein the molded article is a container.

10. The molded article according to claim 7, wherein the molded article is a carrier tape.

[FIG. 1A]

[FIG. 1B]

## INTERNATIONAL SEARCH REPORT

| International application No. |
| --- |
| **PCT/JP2024/006989** |

**A.    CLASSIFICATION OF SUBJECT MATTER**

*B32B 27/00*(2006.01)i; *B32B 27/20*(2006.01)i; *B32B 27/30*(2006.01)i; *B65D 85/90*(2006.01)i
FI:    B32B27/00 104; B32B27/20 Z; B32B27/30 B; B65D85/90 300

According to International Patent Classification (IPC) or to both national classification and IPC

**B.    FIELDS SEARCHED**

Minimum documentation searched (classification system followed by classification symbols)

B32B27/00; B32B27/20; B32B27/30; B65D85/90

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2011/118522 A1 (DENKI KAGAKU KOGYO KABUSHIKI KAISHA) 29 September 2011 (2011-09-29)<br>claims, paragraph [0020], examples 1-14 | 1-10 |
| A | JP 2012-51249 A (DENKI KAGAKU KOGYO KABUSHIKI KAISHA) 15 March 2012 (2012-03-15)<br>claims, paragraph [0014], examples 1-12 | 1-10 |
| A | WO 2006/030871 A1 (DENKI KAGAKU KOGYO KABUSHIKI KAISHA) 23 March 2006 (2006-03-23)<br>claims, examples 1-11 | 1-10 |
| A | JP 10-7857 A (DENKI KAGAKU KOGYO KABUSHIKI KAISHA) 13 January 1998 (1998-01-13)<br>claims, examples 1-12 | 1-10 |
| A | JP 10-110073 A (ASAHI CHEMICAL INDUSTRY CO., LTD.) 28 April 1998 (1998-04-28)<br>claims, examples 1-7 | 1-10 |

| ✓ Further documents are listed in the continuation of Box C. | ✓ See patent family annex. |
| --- | --- |

\*    Special categories of cited documents:
"A"    document defining the general state of the art which is not considered to be of particular relevance
"D"    document cited by the applicant in the international application
"E"    earlier application or patent but published on or after the international filing date
"L"    document which may throw doubts on priority claim(s) or which is cited to establish the publication date of another citation or other special reason (as specified)
"O"    document referring to an oral disclosure, use, exhibition or other means
"P"    document published prior to the international filing date but later than the priority date claimed

"T"    later document published after the international filing date or priority date and not in conflict with the application but cited to understand the principle or theory underlying the invention
"X"    document of particular relevance; the claimed invention cannot be considered novel or cannot be considered to involve an inventive step when the document is taken alone
"Y"    document of particular relevance; the claimed invention cannot be considered to involve an inventive step when the document is combined with one or more other such documents, such combination being obvious to a person skilled in the art
"&"    document member of the same patent family

| Date of the actual completion of the international search | Date of mailing of the international search report |
| --- | --- |
| **14 May 2024** | **21 May 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

International application No.

**PCT/JP2024/006989**

| C. | DOCUMENTS CONSIDERED TO BE RELEVANT | |
|---|---|---|
| Category* | Citation of document, with indication, where appropriate, of the relevant passages | Relevant to claim No. |
| A | JP 2005-41972 A (CHISSO CORPORATION) 17 February 2005 (2005-02-17) claims, examples 1-3 | 1-10 |
| A | JP 1-192548 A (BAYER AKTIENGESELLSCHAFT) 02 August 1989 (1989-08-02) claims, examples | 1-10 |

Form PCT/ISA/210 (second sheet) (July 2022)

**EP 4 678 396 A1**

| INTERNATIONAL SEARCH REPORT | International application No. |
| Information on patent family members | PCT/JP2024/006989 |

| Patent document cited in search report | | | Publication date (day/month/year) | Patent family member(s) | | | Publication date (day/month/year) |
|---|---|---|---|---|---|---|---|
| WO | 2011/118522 | A1 | 29 September 2011 | US | 2013/0017350 | A1 | |
| | | | | CN | 102821951 | A | |
| | | | | KR | 10-2013-0000413 | A | |
| JP | 2012-51249 | A | 15 March 2012 | (Family: none) | | | |
| WO | 2006/030871 | A1 | 23 March 2006 | TW | 200616791 | A | |
| JP | 10-7857 | A | 13 January 1998 | (Family: none) | | | |
| JP | 10-110073 | A | 28 April 1998 | (Family: none) | | | |
| JP | 2005-41972 | A | 17 February 2005 | (Family: none) | | | |
| JP | 1-192548 | A | 02 August 1989 | EP | 320702 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012051249 A